# EUROPÄISCHE PATENTSCHRIFT

(11) **EP 1 520 330 B1**
(45) Veröffentlichungstag und Bekanntmachung des Hinweises auf die Patenterteilung: **20.08.2008**
(21) Anmeldenummer: 03720184.5
(22) Anmeldetag: 15.03.2003
(51) Int. Cl.: H02B 1/20, H01R 9/26, H05K 7/14

(54) **TRÄGER FÜR MODULGEHÄUSE**
SUPPORT FOR MODULE CASES
SUPPORT POUR BOITIER DE MODULES

(30) Priorität: 05.07.2002 DE 10230292
(43) Veröffentlichungstag der Anmeldung: 06.04.2005
(73) Patentinhaber: R. Stahl Schaltgeräte GmbH, 74638 Waldenburg (DE)
(72) Erfinder: DANKO, Franz, 74635 Kupferzell (DE); EUSTERHOLZ, Helmut, 33102 Paderborn (DE)
(74) Vertreter: Rüger, Barthelt & Abel Patentanwälte
(86) Internationale Anmeldenummer: PCT/DE2003/000841
(87) Internationale Veröffentlichungsnummer: WO 2004/006397

(56) Entgegenhaltungen:
- EP-A- 0 896 504
- DE-A- 3 633 785
- DE-A- 19 748 531
- DE-A- 19 807 710
- FR-A- 2 789 525

## Beschreibung

In dem Maße, in dem die elektronischen Schaltungen kleiner werden, weil die Bauteile schrumpfen oder ein höheres Integrationsmaß der Halbleiterelemente verwendet wird, schrumpfen auch die Modulgehäuse, in denen solche Schaltungen untergebracht sind. Die Zahl der erforderlichen Kontaktstellen verhält sich gerade umgekehrt, d.h. je höher die Integrationsdichte ist, um so mehr Funktionen werden in einem Modulgehäuse untergebracht, mit der Folge einer entsprechenden hohen Anzahl elektrischer Verbindungen, über die die Schaltung in dem Modulgehäuse mit der Umgebung in Verbindung steht. Es finden also zwei Entwicklungen statt, die die Kontaktierung eines Modulgehäuses erschweren.

An den Außenwänden eines Modulgehäuses herrscht notorischer Platzmangel für die unterzubringenden Kontaktstellen.

Die Problematik verstärkt sich weiter, wenn die Modulgehäuse auf einer Hutschiene angebracht werden sollen. Damit fallen die Flachseiten, an denen die Modulgehäuse nebeneinander liegen, zur Kontaktierung weg.

An der Frontseite ist für gewöhnlich auch kein Platz hierfür, denn dort müssen Anzeige- und Meldeeinrichtungen untergebracht werden.

Um mit dem notorischen Platzmangel einigermaßen fertig zu werden, wurde bereits versucht, auf einer Hutschiene einen Modulträger aufzubringen, wie in der DE 196 51 961 gezeigt ist. Der Modulträger weist an der Rückseite eine Halteeinrichtung zur Aufbringung auf einer Hutschiene auf. Seine Vorderseite trägt eine Vielzahl von Steckverbindern, auf die das Modulgehäuse mit seiner Rückseite aufsteckbar ist. Die Steckverbinder sind als Buchsen oder Steckerstifte ausgeführt und erzwingen einen geraden Weg beim Aufstecken.

Der Träger eignet sich nicht zum Halten von Modulgehäusen, die an sich zur Befestigung an einer Hutschiene geeignet sind und mit entsprechenden Kontakten zur Verbindung mit Steckverbindern innerhalb der Hutschiene eingerichtet sind.

Außerdem ist die Zahl der Kontaktstellen bei der bekannten Anordnung immer noch stark beschränkt.

Ausgehend hiervon ist es Aufgabe der Erfindung, einen neuen Träger für Modulgehäuse zu schaffen, der eine größere Anzahl von Kontaktstellen zulässt und/oder die Verwendung von Kontaktstellen, von denen jede für sich einen größeren Platzbedarf aufweist.

Diese Aufgabe wird erfindungsgemäß mit einem Träger mit dem Merkmalen des Anspruches 1 gelöst.

DE 197 48531 offenbant einen Tnäfer fär Modulgehäuse unt einer Verankermupreiwuichtung auf einem Schenkel und einer ersten und einer zwerten Gruppe ven Stechveroinder.

Der neue Träger weist zwei im Winkel zueinander angeordnete Schenkel auf, von denen jeder mit einer Gruppe von Steckverbindern versehen ist. Auf diese Weise können ohne weiteres zwei Schmalseiten eines Modulgehäuses zur Kontaktierung herangezogen werden, wodurch sich die Anzahl der Kontaktstellen wesentlich vergrößert. Andererseits ist es möglich, bei gleicher Zahl von Kontaktstellen größere Kontaktstellen unterzubringen, beispielsweise solche Kontaktstellen für Adapter, die zur Schraub- oder Klemmbefestigung einer äußeren Verdrahtung geeignet sind.

Der Träger für die Modulgehäuse ist mit einer hintergriffigen Verankerungseinrichtung versehen, auf die die Modulgehäuse in einer Art Schwenkbewegung aufgesetzt werden. Die Gruppen von Steckverbindern sind jeweils so gestaltet, dass sie die Schwenkbewegung nicht behindern.

Die Schwenkbewegung beim Aufsetzen der Modulgehäuse geschieht um eine Achse, die zweckmäßigerweise auf jener Fläche senkrecht steht, die die beiden Schenkel aufspannen.

Die Universalität wird gesteigert, wenn die beiden Schenkel in Richtung parallel zu der Achse der Schwenkbewegung jeweils gleiche Ausdehnungen aufweisen.

Der Träger kann zur Aufnahme eines einzelnen Modulgehäuses oder einer Reihe von nebeneinander angeordneten Modulgehäusen eingerichtet sein. Im letzteren Falle haben die Schenkel in Richtung parallel zur Achse der Schwenkbewegung eine Ausdehnung, die der Breite von mehreren nebeneinander angeordneten Modulgehäusen entspricht und sie tragen auch eine entsprechende Anzahl von ersten und zweiten Gruppen von Steckverbindern.

Der erfindungsgemäß Träger kann seinerseits zur Halterung auf einer Hutschiene eingerichtet sein. Hierzu ist an der Rückseite eines der Schenkel, d.h. an derjenigen Seite, die von dem Winkelbereich abliegt, eine Hutschienenhalterung vorgesehen.

Der Winkel, den die beiden Schenkel miteinander einschließen, ist weitgehend frei wählbar. Im Interesse einer möglichst hohen Packungsdichte, beispielsweise in einem Schaltschrank oder dgl., ist es von Vorteil, wenn die Schenkel einen Winkel von 90° miteinander einschließen.

Die Verankerungseinrichtung für die Modulgehäuse auf einem der Schenkel ist zweckmäßigerweise zu Hutschienen kompatibel, so dass die Hutschienenhaltereinrichtung, die an dem Modulgehäuse vorgesehen ist, auch dazu herangezogen werden kann, das Modulgehäuse auf dem betreffenden Schenkel festzulegen.

Hierzu weist im einfachsten Falle der betreffende Schenkel eine hakenförmige Leiste auf, die gleichzeitig auch die Achse der Schwenkbewegung festlegt und die sich in Richtung von dem anderen Schenkel weg öffnet.

Damit das Modulgehäuse nicht von der hakenförmigen Leiste einfach abgezogen werden kann, ist zweckmäßigerweise noch eine zweite Anschlagleiste vorgesehen. So ist nur über eine Schwenkbewegung eine Trennung des Modulgehäuses von dem Träger möglich.

Die erste Gruppe von Steckverbindern kann vorteilhafterweise zumindest zum Teil zwischen der Anschlagleiste und der hakenförmigen Leiste untergebracht sein. Auf diese Weise wird mit solchen Anwendungen eine Kompatibilität hergestellt, bei denen das Modulgehäuse auf einer Hutschiene mechanisch gehalten wird, die in sich Kontaktierungselemente, beispielsweise Steckverbinder für das betreffende Modulgehäuse enthält.

Die Gruppe von Steckverbindern des Modulgehäuses, die mit der zweiten Gruppe von Steckverbindern des Trägers zusammenwirken können bei Einzelanwendung des Modulgehäuses auch mit steckbaren Anschlussklemmen für eine äußere Verdrahtung versehen werden.

Eine besonders einfache Ausführungart von Steckverbindern, die die Schwenkbewegung nicht behindert, besteht in der Verwendung von Kontaktelementen mit ebenen oder balligen Kontaktflächen. Die ebenen oder balligen Kontaktflächen sind im Wesentlichen parallel zu einer Ebene ausgerichtet, die die Achse der Schwenkbewegung rechtwinklig schneidet. Beim Einsetzen des Modulgehäuses und der erforderlichen Schwenkbewegung streifen die komplementären Kontaktflächen an dem Modulgehäuse an den ortsfesten Kontaktflächen der ersten Gruppe von Steckverbindern vorbei.

Dieselbe Art von Steckverbindern kann auch für die zweite Gruppe von Steckverbindern verwendet werden.

Wenn die zweite Gruppe von Steckverbindern einen großen radialen Abstand von der Achse der Schwenkbewegung aufweist, können auch Buchsen oder Steckerstifte eingesetzt werden. Der Kontakthub ist verhältnismäßig klein, und außerdem sind in der Regel entweder die Steckerstifte oder die Buchsen, gegebenenfalls auch beide in den zugehörigen Isolierstoffgehäusen schwimmend gelagert, so dass er eine geringfügige Ausgleichsbewegung vollführen können. Auf diese Weise ist es möglich, den an sich bogenförmigen Weg durch die lineare Achse der geraden Steckbuchse oder des geraden Steckerstiftes anzunähern. Die Steckerstifte und die Buchse können exakt gerade sein.

Damit eine Behinderung der Schwenkbewegung nicht erfolgt, sind sie so ausgerichtet, dass ihre Achse auf einer Tangente zu einem Kreis liegt, dessen Mittelpunkt die Achse der Schwenkbewegung beim Einsetzen des Modulgehäuses ist. Der Radius des Kreises entspricht dem Abstand, den der jeweils komplementäre Steckverbinder in dem Modulgehäuse von der besagten Achse selbst hat.

Im Falle der Verwendung von Kontaktelementen mit flächiger Kontaktfläche, also einer solchen Fläche, die das komplementäre Gegenstück nicht an mehreren Seiten umgreift, kann die betreffende Gruppe aus Steckverbindern auch aus zwei Reihen von solchen flächigen Kontaktelementen bestehen. Zwischen ihnen ist ein Schlitz vorhanden, in den die komplementären Kontaktflächen am Modulgehäuse eingeführt werden. Hierdurch lässt sich die Zahl der möglichen Kontaktstellen noch weiter erhöhen.

Im Übrigen sind Weiterbildungen der Erfindung Gegenstand von Unteransprüchen. Dabei sollen auch solche Merkmalskombinationen als beansprucht angesehen werden, auf die kein ausdrückliches Ausführungsbeispiel gerichtet ist.

In der Zeichnung ist ein Ausführungsbeispiel des Gegenstandes der Erfindung nachgestellt, es zeigen:
- Figur 1: den erfindungsgemäßen Träger auf einer Hutschiene in Verbindung mit einem aufgesetzten Modulgehäuse, in einer perspektivischen Darstellung, und
- Figur 2: den Träger nach Figur 1 in einer Seitenansicht und teilweise aufgebrochen.

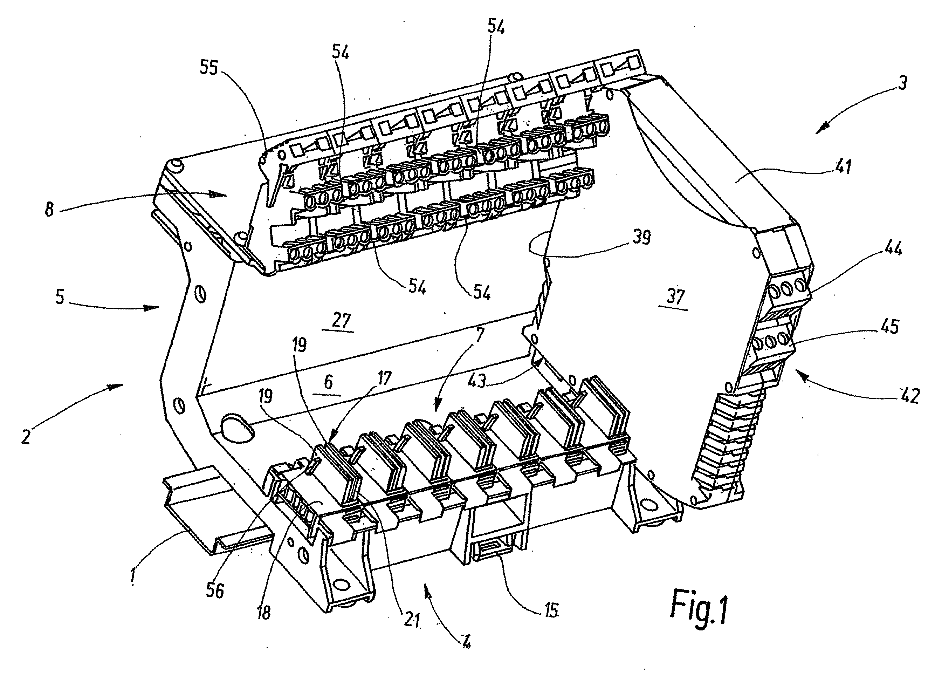

Figur 1 zeigt in einer schematischen Darstellung einen auf einer Hutschiene 1 befestigten Träger 2, auf dem mehrere Modulgehäuse 3 zu befestigen sind, von denen lediglich eines dargestellt ist.

Der Träger 2 weist einen ersten Schenkel 4 sowie einen zweiten Schenkel 5 auf, die beide eine etwa plattenförmige Gestalt haben und die im rechten Winkel zueinander verlaufen. Sie sind an einer Übergangsstelle 6 einstückig miteinander verbunden.

Der Schenkel 4 trägt eine erste Gruppe von Steckverbindern 7 und der Schenkel 5 eine zweite Gruppe von Steck-verbindern 8. Mit Hilfe der beiden Gruppen von Steckverbindern 7 und 8 werden elektrische Kontakte zu elektronischen Bauteilen in dem Modulgehäuse 3 hergestellt.

Um den Träger 2 auf der Hutschiene 1 zu befestigen, enthält er in der Rückseite seines ersten Schenkels 4 eine in Längsrichtung verlaufende durchgehende Nut mit etwa trapezförmigem Querschnitt, die sich in Richtung zur Rückseite des Schenkels 4 öffnet. Die Nut 11 verläuft somit parallel zu dem Übergangsbereich 6.

In ihrer dem Übergangsbereich 6 benachbarten Nutenwand 12 enthält sie in der Nähe ihres Nutengrunds 13 eine weitere Nut 14, wodurch eine hintergriffene Konfiguration erhalten wird. Die Nut 14 dient, wie gezeigt, zur Aufnahme eines seitlich wegstehenden Flansches der Hutschiene.

Auf der gegenüberliegenden Seite ist in dem ersten Schenkel 4 ein Verriegelungsschieber 15 längsverschieblich gelagert, der mit Hilfe einer nicht veranschaulichten Feder in eine in die Nut 11 vorstehende Position vorgespannt ist. Der Schieber 14 dient dazu, wie dargestellt, den anderen Flansch der Hutschiene 1 zu hintergreifen.

Zur Aufnahme der ersten Gruppe von Steckverbindern 7 ist auch in der nach oben zeigenden Flachseite des ersten Schenkels 4 eine weitere Nut 16 enthalten, in der nebeneinander mehrere Steckverbinderleisten 17 enthalten sind. Die Steckverbinderleisten sind in Längsrichtung der Nut nebeneinander aufgereiht und in den Figuren erkennbare Steckverbinder sind untereinander elektrisch verbunden, derart, dass sie eine Art durchgehende elektrische Schiene ergibt.

Das Isolierstoffgehäuse der Steckverbinder 17 bildet einen unteren Abschnitt 18, der in der Nut 16 liegt und aus dem zwei parallel zueinander verlaufende Wände 19 aufragen. Die Isolierstoffwände 19 begrenzen zwischen sich einen Schlitz 21. Der Schlitz 21 ist von der Oberseite des Schenkels 4 weg offen und außerdem in Richtung auf beiden Enden. Es entsteht insgesamt ein Schlitz, der sich in Richtung senkrecht zu dem Verbindungsbereich 6 erstreckt.

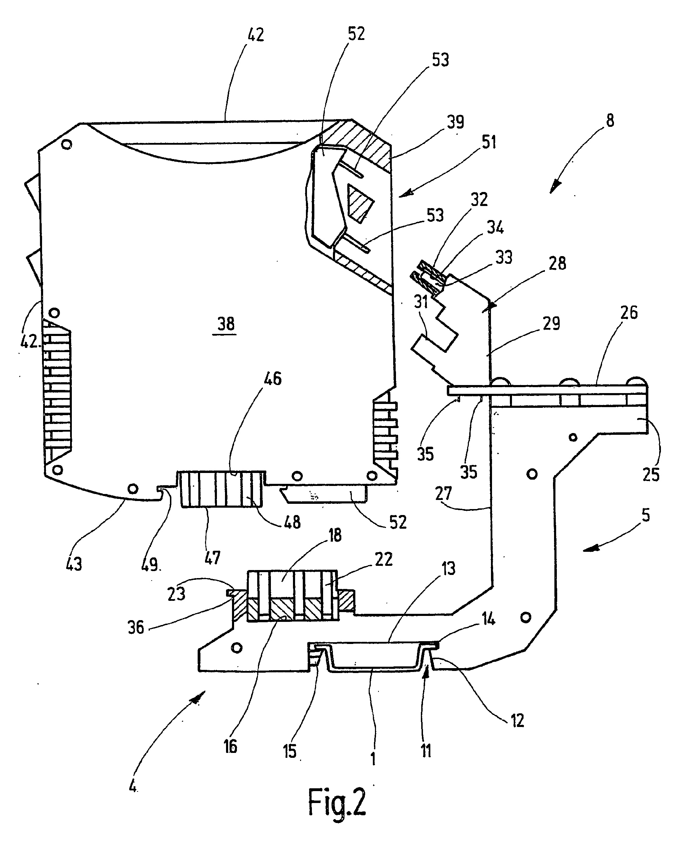

Auch an den einander gegenüberstehenden Seiten der Wände 19 sind jeweils mehrere Kontaktelemente 22 gehaltert, wie dies in Figur 2 zu erkennen ist. Die Kontaktelemente 22 sind mit den Kontakten elektrisch verbunden, über die auch die Steckverbinder 17 untereinander elektrisch in Verbindung stehen.

Die Kontaktelemente 22 sind im Wesentlichen flache Kontaktzungen, die entsprechend in den Schlitz 21 vorragen.

Auf der von dem Schenkel 5 abliegenden Seite bildet die Nut 16 eine hakenförmige Leiste 23, die in einer weiter unten beschriebenen Weise mit dem Modulgehäuse zusammenwirkt. Die hakenförmige Leiste 23 öffnet sich, wie gezeigt, in Richtung von dem Schenkel 5 weg. Sie dient nun dazu, einen Teil der Hutschiene 1 mit einem Flansch nachzubilden.

Der andere Schenkel 5 ist an seinem oberen Ende mit einem über die Rückseite überstehenden Fortsatz 25 versehen, auf dessen Oberseite eine Leiterplatte 26 befestigt ist. Die Leiterplatte 26 steht über eine nach innen zeigende glatte Vorderseite 27 des Schenkels 5 über. Sie trägt auf ihrer nach oben zeigenden Seite eine Steckverbinderleiste 28, die die zweite Gruppe von Steckverbindern 8 darstellt. Ihr Isolierstoffgehäuse 29 bildet zwei schräg nach oben und nach links zeigende Reihe von Fortsätzen 31 und 32. In den leistenartigen Fortsätzen 31 und 32 sind, wie die vergrößerte Darstellung in dem Kreis von Figur 2 zeigt, Steckbuchsen 33 in entsprechenden Buchsenräumen 34 angeordnet. Die Steckbuchsen 33 sind über nicht weiter veranschaulichte Leiter mit Lötstiften 35 verbunden, die in der Leiterplatte 26 eingelötet sind.

Die Steckbuchsen 33 sind derart ausgerichtet, dass sie tangential zu einem Kreis liegen, dessen Mittelpunkt durch eine Innenecke 36 der Hakenleiste 23 definiert ist.

Das Modulgehäuse 3 ist ein im Wesentlichen flaches, quaderförmiges Gehäuse, das von zwei Flachseiten 37 und 38 sowie vier Schmalseiten 39, 41, 42 und 43 begrenzt ist. In der Schmalseite 42 sind übereinander zwei Schraubklemmenreihen 44 und 45 vorgesehen.

In der unteren Schmalseite 23 enthält das Gehäuse eine Öffnung 46, aus der eine von einer in dem Modulgehäuse 3 befindlichen Leiterplatte gebildete Lasche 47 vorsteht, die beidseits mit Leiterbahnen 48 versehen ist. Sie dienen als Kontaktelement, die mit den Kontaktelementen 22 der Steckverbinderleisten 17 zusammenwirken.

In Richtung auf die vordere Schmalseite 42 hin befindet sich neben der Leiterplattenlasche 47 eine hakenförmige Nut 49, die dazu eingerichtet ist, auf einem seitlich wegstehenden Flansch einer Hutschiene 1 eingehakt zu werden. Der Nut 49 gegenüber ist in der unteren Schmalseite 43 ein Verriegelungsschieber 50 verschieblich gelagert, der den gegenüberliegenden Flansch einer Hutschiene 1 hintergreift, wenn das Modulgehäuse 3 unmittelbar auf einer Hutschiene 1 befestigt werden soll.

Im Bereich der hinteren Schmalseite 39 weist das Modulgehäuse 3 eine größere Öffnung 51 auf, durch die hindurch eine weitere Steckverbinderleiste 52 zugänglich ist, die auf der in dem Modulgehäuse befindlichen Leiterplatte aufgelötet ist. Die Steckverbinderleiste 52 haltert eine Reihe von Steckerstiften 53, die in schräger Richtung gegenüber der rückwärtigen Schmalseite 39 verlaufen.

Da das Modulgehäuse 3 deutlich schmäler ist, als die Leisten 31 und 32 lang sind, enthalten diese beiden Leisten entsprechend der Breite des Modulgehäuses 3 oder einem Vielfachen davon Querschlitze 54, wie sie in Figur 1 zu sehen sind. In diese Querschlitze 54 dringen in der Umgebung 51 die Seitenwände entsprechend den Flachseiten 37 und 38 ein, wenn das Modulgehäuse 3 eingesetzt ist.

Das Aufsetzen eines Modulgehäuses 3 auf den Träger 2 geschieht in der folgenden Weise:

Das Modulgehäuse 3 wird mit der Nut 49 auf die Hakenleiste verkippt aufgesetzt, wobei die Leiterbahnlasche 47 in den Schlitz 21 der Steckverbinderleiste 17 an der gewünschten Position eintaucht. Da das Modulgehäuse 3 zunächst noch verkippt ist, so dass seine Rück- oder Schmalseite 39, die dem Schenkel 5 gegenüber steht, unter einem spitzen Winkel zu den Schenkel 5 verläuft, stehen auch die Leiterbahnen 48 im Winkel zu den Kontaktfederzungen 22. Die Leisten 31 und 32 des Steckverbinders 28 befinden sich im Abstand von der rückwärtigen Schmalseite 39 außerhalb der Öffnung 51. Sodann wird das Modulgehäuse 3 um eine Achse in Richtung auf den Schenkel 5 geschwenkt, die durch die Innenecke 36 der Hakenleiste 23 definiert ist. Im Verlauf dieser Schwenkbewegung dringen die Leisten 31 und 32 in die Öffnung 51 ein und im weiteren Verlauf der Schwenkbewegung gleiten die Steckerstifte 53 in die zugehörigen Buchsen 33.

Obwohl sich die Steckerstifte 53 bei diesem Teil der Montagebewegung längs einer Kreisbahn bewegen und selbst gerade sind, wird die Schwenkbewegung durch den Eingriff zwischen den Steckerstiften 53 und den Buchsen 33 nicht blockiert. Der radiale Abstand von der Schwenkachse in Gestalt der Innenecke 35 ist groß und außerdem sind vorteilhafterweise entweder wenigstens die Steckerstifte 53 oder die Buchsen 33 in dem zugehörigen Isolierstoffgehäuse begrenzt schwimmend gehaltert. Sie können sich entsprechend der Schwenkbewegung hinreichend ausrichten, um Knickkräfte an den Steckerstiften 53 zu vermeiden.

Die Einsetzbewegung ist beendet, wenn die schmale Rückseite 39 des Modulgehäuses 3 zu der Fläche 27 des Schenkels parallel läuft. In dieser Stellung ist auch die untere Schmalseite 43 parallel zu dem Schenkel 4 und es fluchtet mit je einer Kontaktfederzunge 22 eine entsprechende Leiterbahn 48. Durch einen nur in Figur 1 erkennbaren Verriegelungshebel 55 kann das Modulgehäuse 3 dagegen gesichert werden, dass es in der entgegengesetzten Schwenkbewegung von dem Träger 1 herunterfällt.

Um die Schwenkbewegung präzise zu führen und ein Aushaken der Hakenleiste 23 aus der Nut 49 zu verhindern, können auf der Außenseite der Wände 19 bogenförmig gekrümmte Führungsleisten 56 vorhanden sein, die eine Krümmung aufweisen, deren Krümmungsmittelpunkt wiederum die Innenecke 36 darstellt. Sie wirken mit entsprechenden Führungsflächen an der Innenseite der Flachseiten 37 und 38 neben der Leiterbahnlasche 47 zusammen.

Ein Träger für Modulgehäuse setzt sich aus zwei im rechten Winkel zueinander verlaufenden plattenförmigen Schenkeln zusammen. Einer der Schenkel trägt eine erste Gruppe von Steckverbindern und ein anderer Schenkel eine zweite Gruppe von Steckverbindern. Bei der zweiten Gruppe von Steckverbindern sind die dort vorhandenen Buchsen oder Stifte tangential zu einer Kreis ausgerichtet, längs dessen die korrespondierenden Steckerstifte oder Buchsen des Modulgehäuses bewegt werden, wenn das Modulgehäuse zum Zweck der Montage in die Montagestellung geschwenkt wird.

## Patentansprüche

1. Trager für Modulgehäuse (3), die elektrisch zu kontaktierende Bauteile enthalten und hierzu an zwei Seiten Gruppen Steckverbinder (48,51) aufweisen,
mit einem ersten Schenkel (4),
mit einem zweiten Schenkel (5), der mit dem ersten Schenkel (4) einen Winkel einschließt, wobei der zweite Schenkel (5) mit dem ersten Schenkel (4) eine Fläche aufspannt,
mit einer hintergriffigen Verankerungseinrichtung (23), die auf dem ersten Schenkel (4) vorgesehen ist, um ein Modulgehäuse (3) durch eine begrenzte Schwenkbewegung wahlweise zu verankern oder von der das Modulgehäuse (3) durch eine begrenzte Schwenkbewegung zu lösen ist, wobei die Achse der Schwenkbewegung rechtwinkelig zu der Fläche liegt, die die beiden Schenkel (4,5) aufspannen,
mit einer ersten Gruppe (7) von Steckverbindern (22), die an dem ersten Schenkel (4) angeordnet und derart gestaltet sind, dass ein Kontaktieren der Steckverbinder (48) des Modulgehäuses (3) die Schwenkbewegung nicht behindert wird, und
mit einer zweiten Gruppe (8) von Steckverbindern (33), die an dem zweiten Schenkel (5) angeordnet und derart gestaltet sind, dass ein Kontaktieren der Steckverbinder (53) des Modulgehäuses (3) die Schwenkbewegung nicht behindert wird.

2. Träger nach Anspruch 1, **dadurch gekennzeichnet, dass** auf der Fläche, die der erste und der zweite Schenkel (4,5) aufspannen, die Achse der Schwenkbewegung senkrecht steht.

3. Träger nach Anspruch 1, **dadurch gekennzeichnet, dass** die Schenkel (4,5) in Richtung parallel zu der Achse der Schwenkbewegung gleiche Ausdehnung aufweisen.

4. Träger nach Anspruch 1, **dadurch gekennzeichnet, dass** die Schenkel (4,5) in Richtung parallel zu der Achse der Schwenkbewegung eine Ausdehnung aufweisen, die zur Unterbringung von mehr als einer ersten und/oder zweiten Gruppe von Steckverbindern (22,33) ausreicht, die in Richtung parallel zu der Achse der Schwenkbewegung nebeneinander angeordnet sind.

5. Träger nach Anspruch 1, **dadurch gekennzeichnet, dass** wenigstens einer der Schenkel (4,5) an seiner Rückseite, die von der Innenecke zwischen den Schenkeln (4,5) abliegt, eine Hutschienenhalterung (11,15) zur Befestigung des Trägers (2) an einer Hutschiene (1) aufweist.

6. Träger nach Anspruch 1, **dadurch gekennzeichnet, dass** die Schenkel (4,5) einen Winkel von ca 90° miteinander einschließen.

7. Träger nach Anspruch 1, **dadurch gekennzeichnet, dass** die Verankerungseinrichtung (23) zu einer Hutschienenhalterung (46,49,51) kompatibel ist, die an dem Modulgehäuse (3) zur unmittelbaren Halterung an einer Hutschiene (1) vorgesehen ist.

8. Träger nach Anspruch 7, **dadurch gekennzeichnet, dass** die Verankerungseinrichtung (23) wenigstens eine hakenförmige Leiste aufweist, deren Innenecke (35) von dem anderen Schenkel (4,5) weg weist.

9. Träger nach Anspruch 7, **dadurch gekennzeichnet, dass** die Verankerungseinrichtung (23) einen Anschlag (56) aufweist, der im Abstand von der hakenförmigen Leiste (23) angeordnet ist und der sich zwischen der hakenförmigen Leiste (23) und dem anderen Schenkel (4,5) befindet.

10. Träger nach Anspruch 9, **dadurch gekennzeichnet, dass** zumindest ein Teil der Steckverbinder (22) ersten Gruppe (7) von Steckverbindern (22) zwischen der hakenförmigen Leisten (23) und dem Anschlag (56) angeordnet ist.

11. Träger nach Anspruch 1, **dadurch gekennzeichnet, dass** die erste und/oder die zweite Gruppe (7,8) von Steckverbindern (22,33) Kontaktelemente (22) mit ebenen oder balligen Kontaktflächen aufweist, die parallel zu der durch die Schenkel (4,5) aufgespannten Fläche ausgerichtet sind.

12. Träger nach Anspruch 11, **dadurch gekennzeichnet, dass** sich zwei Gruppen von Kontaktelementen mit flachen Kontaktflächen (22) mit ihren Kontaktflächen (22) mit Abstand voneinander gegenüberstehen.

13. Träger nach Anspruch 11, **dadurch gekennzeichnet, dass** die Kontaktelemente (22) in einem zugehörigen Isolierstoffgehäuse (17) untergebracht sind.

14. Träger nach Anspruch 13, **dadurch gekennzeichnet, dass** das Isolierstoffgehäuse (17) einen Schlitz (21) aufweist, der endseitig offen ist und sich in Richtung parallel zu der Fläche, die durch die Schenkel aufgespannt ist erstreckt.

15. Träger nach Anspruch 1, **dadurch gekennzeichnet, dass** die zweite Gruppe (8) von Steckverbindern (33) Steckerstifte oder Steckbuchsen aufweist.

16. Träger nach Anspruch 15, **dadurch gekennzeichnet, dass** die Steckverbinder (33) derart ausgerichtet sind, dass die Achsen der Steckerstifte oder Steckbuchsen (33) tangential zu einem Kreis ausgerichtet sind, der als Mittelpunkt die Achse der Schwenkbewegung hat und dessen Radius dem Abstand des jeweils zugehörigen komplementären Steckverbinders (53) in dem Modulgehäuse (3) entspricht, den dieser Steckverbinder (53) von der Achse hat.

17. Träger nach Anspruch 1, **dadurch gekennzeichnet, dass** einer der Schenkel (5) an seiner Rückseite, die von der Innenecke zwischen den Schenkeln (4,5) abliegt, einen Fortsatz (25) aufweist.

18. Träger nach Anspruch 17, **dadurch gekennzeichnet, dass** der Fortsatz (25) als Halter für eine Leiterplatte (26) dient, auf der als Steckbuchsenleiste (28) die zweite Gruppe (8) von Steckverbindern sitzt.

19. Träger nach Anspruch 18, **dadurch gekennzeichnet, dass** die erste Gruppe (7) von Steckverbinder auf mehrere Steckbuchsenleisten (17) aufgeteilt ist, die nebeneinander in einer Aufnahmenut (16) angeordnet sind, die in dem ersten Schenkel (4) ausgebildet ist.

## Claims

1. Support for modular casings (3), which contains structural parts to be electrically connected and for this purpose have groups of pin-and-socket connectors (48, 51) on two sides,
with a first leg (4),
with a second leg (5), which encloses an angle with the first leg (4), wherein the second leg (5) clamps a surface with the first leg (4),
with an anchoring means (23) engaging behind, which is provided on the first leg (4) to selectively anchor modular casing (3) by a restricted pivoting movement or from which the modular casing (3) can be released by a restricted pivoting movement, wherein the axis of the pivoting movement lies at right angles to the surface, which the two legs (4, 5) clamp,
with a first group (7) of pin-and-socket connectors (22), which are arranged on the first leg (4) and are configured in such a way that the pivoting movement is not hindered by a connection of the pin-and-socket connectors (48) of the modular casing (3), and
with a second group (8) of pin-and-socket connectors (33), which are arranged on the second leg (5) and are configured in such a way that the pivoting movement is not hindered by a connection of the pin-and-socket connectors (53) of the modular casing (3).

2. Support according to claim 1, **characterised in that** the axis of the pivoting movement stands vertically on the surface, which the first and the second leg (4, 5) clamp.

3. Support according to claim 1, **characterised in that** the legs (4, 5) have the same extent in a direction parallel to the axis of the pivoting movement.

4. Support according to claim 1, **characterised in that** in a direction parallel to the axis of the pivoting movement the legs (4, 5) have an extent, which is sufficient to accommodate more than a first and/or second group of pin-and-socket connectors (22, 33), which are arranged adjacent to one another in a direction parallel to the axis of the pivoting movement.

5. Support according to claim 1, **characterised in that** on its rear side remote from the inside corner between the legs (4, 5) at least one of the legs (4, 5) has a top hat rail mounting (11, 15) for fastening the support (2) to a top hat rail (1).

6. Support according to claim 1, **characterised in that** the legs (4, 5) enclose an angle of approximately 90° with one another.

7. Support according to claim 1, **characterised in that** the anchoring means (23) is compatible with a top hat rail mounting (46, 49, 51), which is provided on the modular casing (3) for direct mounting on a top hat rail (1).

8. Support according to claim 7, **characterised in that** the anchoring means (23) has at least one hook-shaped bar, the inside corner (35) of which points away from the other leg (4, 5).

9. Support according to claim 7, **characterised in that** the anchoring means (23) has a stop (56), which is arranged at a distance from the hook-shaped bar (23) and which is located between the hook-shaped bar (23) and the other leg (4, 5).

10. Support according to claim 9, **characterised in that** at least part of the pin-and-socket connectors (22) [of the?] first group (7) of pin-and-socket connectors (22) is arranged between the hook-shaped bar (23) and the stop (56).

11. Support according to claim 1, **characterised in that** the first and/or the second group (7, 8) of pin-and-socket connectors (22, 33) has contact elements (22) with plane or cambered contact surfaces, which are oriented parallel to the surface clamped by the legs (4, 5).

12. Support according to claim 11, **characterised in that** two groups of contact elements with flat contact surfaces (22) are spaced opposite one another with their contact surfaces (22).

13. Support according to claim 11, **characterised in that** the contact elements (22) are housed in an associated insulation material casing (17).

14. Support according to claim 13, **characterised in that** the insulation material casing (17) has a slot (21), which is open at the end and extends in a direction parallel to the surface, which is clamped by the legs.

15. Support according to claim 1, **characterised in that** the second group (8) of pin-and-socket connectors (33) has pins or sockets.

16. Support according to claim 15, **characterised in that** the pin-and-socket connectors (33) are oriented such that the axes of the pins or sockets (33) are oriented tangentially to a circle, which has the axis of the pivoting movement as centre point and the radius of which corresponds to the distance of the respectively associated complementary pin-and-socket connector (53) in the modular casing (3), at which this pin-and-socket connector (53) is located from the axis.

17. Support according to claim 1, **characterised in that** one of the legs (5) has an extension (25) on its rear side remote from the inside corner between the legs (4, 5).

18. Support according to claim 17, **characterised in that** the extension (25) serves as holder for a printed circuit board (26), on which the second group (8) of pin-and-socket connectors sits as socket connector strip (28).

19. Support according to claim 18, **characterised in that** the first group (7) of pin-and-socket connectors is divided over a plurality of socket connector strips (17), which are arranged adjacent to one another in a receiving groove (16), which is configured in the first leg (4).

## Revendications

1. Support pour boîtier de modules (3) qui contient des composants à connecter électriquement et présente à cette fin deux groupes de connecteurs enfichables, ce support comprenant :
- une première aile (4),
- une seconde aile (5) qui fait avec la première un angle (4) et définit avec celle-ci une surface,
- un dispositif d'ancrage (23) par pinçage arrière, prévu sur la première aile (4) pour ancrer ou dégager un boîtier de modules (3) en effectuant un mouvement limité de basculement dont l'axe est perpendiculaire à la surface définie par les deux ailes (4, 5),
- un premier groupe (7) de connecteurs enfichables (22) disposés sur la première aile (4) et configurés de manière que l'état de contact (5) des connecteurs enfichables (48) du boîtier de modules (3) ne fait pas obstacle au mouvement de basculement,
- un second groupe (8) de connecteurs enfichables (33) disposés sur la seconde aile (5) et configurés de manière que l'état de contact des connecteurs enfichables (53) du boîtier de modules (3) ne fait pas obstacle au mouvement de basculement.

2. Support selon la revendication 1, **caractérisé en ce que** l'axe du mouvement de basculement est perpendiculaire à la surface définie par la première et la seconde aile (4, 5).

3. Support selon la revendication 1, **caractérisé en ce que** les ailes (4, 5) présentent, parallèlement à l'axe du mouvement de basculement, la même étendue.

4. Support selon la revendication 1, **caractérisé en ce que** les ailes (4, 5) présentent, parallèlement à l'axe du mouvement de basculement, une étendue suffisante pour permettre l'installation de plus d'un premier et/ou d'un second groupe de connecteurs enfichables (22, 33), qui sont disposés côte à côte selon une direction parallèle à l'axe du mouvement de basculement.

5. Support selon la revendication 1, **caractérisé en ce qu'**au moins une des ailes (4, 5) présente, sur sa face arrière qui est éloignée de l'angle interne que font les ailes (4, 5), un support de profilé chapeau (11, 15) pour fixer le support (2) sur un profilé chapeau (1).

6. Support selon la revendication 1, **caractérisé en ce que** les ailes (4, 5) font entre elles un angle d'environ (90°).

7. Support selon la revendications 1, **caractérisé en ce que** le dispositif d'ancrage (23) est compatible avec un support de profilé chapeau (46, 49, 51) prévu sur le boîtier de modules (3) pour assurer un support direct sur un profilé chapeau (1).

8. Support selon la revendication 7, **caractérisé en ce que** le dispositif d'ancrage (23) comprend au moins une barrette en forme de crochet dont l'angle interne (36) est dirigé vers l'autre aile (5).

9. Support selon la revendication 7, **caractérisé en ce que** le dispositif d'ancrage (23) présente une butée (56) qui est disposée à une certaine distance de la barrette (23) en forme de crochet et se trouve entre cette barrette et l'autre aile (5).

10. Support selon la revendication 9, **caractérisé en ce qu'**au moins une partie des connecteurs enfichables (22) constituant le premier groupe de connecteurs, est disposée entre les barrettes (23) en forme de crochets et les butées (56).

11. Support selon la revendication 1, **caractérisé en ce que** le premier et/ou le second groupe (7, 8) de connecteurs enfichables (22, 33) présente des éléments de contact (22) qui ont leurs portées de contact, planes ou bombées, et disposées parallèlement à la surface définie par les ailes (4, 5).

12. Support selon la revendication 11, **caractérisé en ce qu'**il comporte deux groupes d'éléments de contact qui ont des portées de contact (22) plates et qui se font face avec un certain espacement.

13. Support selon la revendication 11, **caractérisé en ce que** les éléments de contact (22) sont disposés dans un boîtier en matériau isolant (17) correspondant.

14. Support selon la revendication 13, **caractérisé en ce que** le boîtier en matériau isolant (17) présente une fente (21) ouverte à son extrémité et parallèle à la surface définie par les ailes.

15. Support selon la revendication 1, **caractérisé en ce que** le seconde groupe (8) de connecteurs enfichables (33) est constitué par des fiches ou des douilles enfichables.

16. Support selon la revendication 15, **caractérisé en ce que** les connecteurs enfichables (33) sont orientés de manière que les axes des fiches ou douilles enfichables (33) sont tangents à un cercle dont le centre se trouve sur l'axe du mouvement de basculement et dont le rayon correspond à la distance que le connecteur enfichable (53) qui lui est complémentaire dans le boîtier de modules (3) présente par rapport à l'axe.

17. Support selon la revendication 1, **caractérisé en ce qu'**une des ailes (5) présente sur sa face arrière éloignée de l'angle intérieur des deux ailes (4, 5), un appendice (25).

18. Support selon la revendication 17, **caractérisé en ce que** l'appendice (25) sert de support à une plaque de conducteurs (26) sur laquelle est monté sous forme d'une barrette de douilles enfichables (28), le second groupe de connecteurs enfichables.

19. Support selon la revendication 18, **caractérisé en ce que** le premier groupe (7) de connecteurs enfichables est divisé en plusieurs barrettes à douilles enfichables (17) disposées les unes à côté des autres dans une rainure d'accueil (16) réalisée dans la première aile (4).
